(19) **Europäisches Patentamt / European Patent Office / Office européen des brevets**

(11) **EP 4 387 014 B1**

(12) **FASCICULE DE BREVET EUROPEEN**

(45) Date de publication et mention de la délivrance du brevet:
**03.09.2025 Bulletin 2025/36**

(21) Numéro de dépôt: **23215979.8**

(22) Date de dépôt: **12.12.2023**

(51) Classification Internationale des Brevets (IPC):
**H01S 5/02** (2006.01)    **H01S 5/20** (2006.01)

(52) Classification Coopérative des Brevets (CPC):
**H01S 5/2027; H01S 5/021; H01S 5/0216; H01S 5/2031**

(54) **SYSTÈME COMPRENANT UNE SOURCE LUMINEUSE SUR UN SUBSTRAT À FORT INDICE OPTIQUE ET PROCÉDÉ ASSOCIÉ**

SYSTEM MIT EINER LICHTQUELLE AUF EINEM SUBSTRAT MIT HOHEM OPTISCHEN INDEX UND VERFAHREN DAFÜR

SYSTEM COMPRISING A LIGHT SOURCE ON A SUBSTRATE WITH A HIGH OPTICAL INDEX AND ASSOCIATED METHOD

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **16.12.2022 FR 2213549**

(43) Date de publication de la demande:
**19.06.2024 Bulletin 2024/25**

(73) Titulaire: **Commissariat à l'Energie Atomique et aux Energies Alternatives**
**75015 Paris (FR)**

(72) Inventeurs:
- **BEN BAKIR, Badhise**
  **38054 GRENOBLE CEDEX 09 (FR)**
- **LARTIGUE, Olivier**
  **38054 GRENOBLE CEDEX 09 (FR)**
- **CONSTANCIAS, Christophe**
  **38054 GRENOBLE CEDEX 09 (FR)**

(74) Mandataire: **Cabinet Camus Lebkiri**
**25 rue de Maubeuge**
**75009 Paris (FR)**

(56) Documents cités:
**CN-A- 101 496 238      US-A1- 2004 208 213**
**US-A1- 2015 260 913**

- **LI X ET AL: "Quality factor control of Si-based two-dimensional photonic crystals with a Bragg mirror", APPLIED PHYSICS LETTERS, AMERICAN INSTITUTE OF PHYSICS, 2 HUNTINGTON QUADRANGLE, MELVILLE, NY 11747, vol. 88, no. 9, 3 March 2006 (2006-03-03), pages 91122 - 091122, XP012083059, ISSN: 0003-6951, DOI: 10.1063/1.2181633**
- **KYUNGMOOK KWON ET AL: "Nano pillar array laser with a bottom metal plane", 2013 INTERNATIONAL CONFERENCE ON OPTICAL MEMS AND NANOPHOTONICS (OMN), IEEE, 6 August 2012 (2012-08-06), pages 230 - 231, XP032261850, ISSN: 2160-5033, ISBN: 978-1-4577-1511-2, DOI: 10.1109/ OMEMS.2012.6318887**

**Description**

**DOMAINE TECHNIQUE DE L'INVENTION**

Le domaine technique de l'invention est celui de l'intégration d'une source lumineuse sur un substrat présentant un fort indice optique.

**ARRIÈRE-PLAN TECHNOLOGIQUE DE L'INVENTION**

Les sources lumineuses intégrables sur un substrat présentent de multiples applications, telles que la détection photoacoustique de composés chimiques. Afin de tirer parti des avantages offerts par plusieurs technologies distinctes, il est recherché d'intégrer des sources lumineuses fabriquées au moyen d'une technologie particulière sur un substrat non issu de cette technologie. On parle alors de technologie « hybride ». Citons par exemple l'intégration de sources lumineuses dites « III-V » sur un substrat semiconducteur en silicium.

Les sources lumineuses III-V sont réalisées à partir d'un alliage semiconducteur dit également « III-V », c'est à dire composé d'un matériau semiconducteur appartement au groupe III (colonne 13 du tableau périodique des éléments) et un matériau semiconducteur appartenant au groupe V (colonne 15 du tableau périodique des éléments). Les alliages fréquents comprennent par exemple l'InP, l'InAs, le GaAs, le GaN, ou encore le InSb. Les sources lumineuses III-V sont de bonnes candidates pour émettre dans un faisceau dans une gamme spectrale étendue, telle que l'infrarouge moyen. Ces sources présentent en revanche des contraintes d'intégration fortes, notamment lorsqu'elles doivent être intégrée au substrat de silicium.

Une source lumineuse de type laser, qu'elle soit de type III-V ou non, comprend une cavité formée par un empilement de couches comprenant une région dite « active » ou « amplificatrice » et deux couches semiconductrices dites « cladding » en anglais. La région active est configurée pour émettre un champ électromagnétique, par émission spontanée et/ou stimulée. Les couches de cladding sont adjacentes à la région active et disposées de part et d'autre de celle-ci pour confiner certains modes du champ électromagnétique, dit « modes guidés ». Afin de confiner efficacement le ou les modes guidés, les couches de cladding présentent des indices optiques strictement inférieurs à l'indice optique moyen de la région active. Par exemple, lorsque la région active est composée d'un multicouches de InGaAs/AlInAs ou de InAlAs/AlGaInAs, les couches de cladding sont alors réalisées en InP.

La source lumineuse, directement disposée sur un substrat Si, peut subir de fortes pertes optiques, handicapantes pour son utilisation. En effet, le silicium a un indice optique supérieur à celui des matériaux III-V, tels que l'InP, et donc supérieur aux couches de cladding. Ainsi, sans disposition particulière et lorsque la pénétration du mode guidé dans les couches de cladding est importante, ledit mode guidé peut se coupler au substrat Si et réduire l'efficacité du confinement offert par les couches de cladding.

Afin de remédier à ce problème, il est proposé que la couche de cladding séparant la région active du substrat Si, dite couche de cladding inférieure, soit relativement épaisse. Elle permet ainsi de compenser la profondeur de pénétration du mode guidé dans les couches de cladding et réduire le couplage du mode guidé avec le substrat Si. Pour un mode guidé présentant une longueur d'onde de 4,5 $\mu$m, l'épaisseur de la couche de cladding inférieure doit atteindre au moins 3,5 $\mu$m. Cela représente un coût en termes de matière brute conséquent et également une contrainte supplémentaire à l'intégration de la source. Pour un mode guidé présentant une longueur d'onde supérieure à 10 $\mu$m (infrarouge lointain), l'épaisseur de la couche de cladding inférieure devrait être supérieure à 20 $\mu$m ce qui peut complexifier davantage l'intégration de la source.

Une solution proposée par le document [Coutard, J.G., Brun, M., Fournier, M. et al. « Volume Fabrication of Quantum Cascade Lasers on 200 mm-CMOS pilot line ». Sci Rep 10, 6185 (2020)], évitant l'épaississement de la couche de cladding inférieure, consiste à insérer une couche de faible indice optique entre la couche de cladding inférieure et le substrat Si. Ladite couche de faible indice fait barrière à la propagation du mode guidé dans le substrat Si et permet de réduire l'épaisseur de la couche de cladding inférieure. Cette couche de faible indice est par exemple en oxyde ou en nitrure. Si le découplage entre la source III-V et le substrat Si est efficace pour un mode guidé présentant une longueur d'onde inférieure à 4 $\mu$m, le constat est différent lorsque le mode guidé présente une longueur d'onde supérieure. En effet, les oxydes ou les nitrures induisent de fortes pertes lorsque la longueur d'onde du mode guidé est supérieure à 4 $\mu$m, ce qui limite grandement la gamme spectrale de la source.

Il existe donc un besoin de fournir un moyen d'intégrer une source lumineuse pouvant fonctionner dans une gamme spectrale étendue, telle qu'une source III-V, sur un substrat présentant un fort indice optique, tel qu'un substrat Si.

US 2015/260913 A1 décrit par ailleurs une source laser à semi-conducteur III-V sur un substrat de silicium présentant une pluralité de sous-couches semiconductrices, dont le profil d'indice de réfraction se distingue néanmoins de celui de l'invention tel que revendiqué.

**RÉSUMÉ DE L'INVENTION**

L'invention permet de résoudre les problèmes précités grâce à la mise en œuvre d'un réflecteur anti-résonant disposé entre la source lumineuse et le substrat. Puisque le réflecteur est basé sur des conditions d'interférence, il peut être réalisé dans des matériaux n'absorbant pas le rayonnement émis par la source. La source lumineuse peut donc fonctionner dans une large gamme spectrale.

Plus particulièrement, l'invention concerne un système (6) comprenant :

- un substrat s'étendant parallèlement à un plan, ledit substrat présentant un indice optique $n_2$ ;
- une source lumineuse configurée pour présenter au moins un mode stationnaire d'un champ électromagnétique, ledit mode étant parallèle au plan, la source étant également configurée pour présenter, pour ledit au moins un mode stationnaire, un indice optique effectif $n_{eff}$ tel que $n_{eff} < n_2$.

Le système est remarquable en ce qu'il comprend également un réflecteur anti-résonant pour ledit au moins un mode stationnaire, ledit réflecteur s'étendant sur le substrat et la source s'étendant sur le réflecteur, le réflecteur comprenant au moins une bicouche semiconductrice s'étendant parallèlement au plan, ladite au moins une bicouche comprenant : une première sous-couche semiconductrice et une deuxième sous-couche semiconductrice, s'étendant contre la première sous-couche, la première sous-couche étant disposée entre la source et la deuxième couche-couche, les première et deuxième sous-couches présentant respectivement des indices optiques $n_{301}$ et $n_{302}$ tels que $n_{301} > n_{302}$ et $n_{301} > n_{eff}$, la première sous-couche présentant également une épaisseur $d_{301}$ configurée pour former une cavité anti-résonante pour ledit au moins un mode stationnaire.

Par mode stationnaire, on entend un mode d'un champ électromagnétique qui est confiné dans une cavité résonnante.

Par mode parallèle au plan, on peut entendre que le champ électromagnétique est transverse par rapport au plan. Par mode électromagnétique transverse par rapport au plan, on peut entendre que le mode guidé présente, de manière exclusive, une polarisation électrique du champ électromagnétique normale au plan ou une polarisation magnétique du champ magnétique normale au plan.

Par indice optique, on entend également indice de réfraction.

Par indice optique effectif, on entend l'indice optique vu par le mode stationnaire dans la source.

Par « réflecteur s'étendant sur le substrat », on entend que le réflecteur et le substrat sont en regard l'un de l'autre et que le substrat peut s'étendre, soit directement contre avec substrat, soit être séparé du substrat par une couche intermédiaire.

Par réflecteur anti-résonant, on entend que le réflecteur est basé sur le principe d'interférences destructives dudit au moins un mode stationnaire, bloquant la transmission du mode guidé à travers le substrat.

Par « épaisseur $d_{301}$ configurée pour former une cavité anti-résonante pour ledit au moins un mode », on entend que l'épaisseur de la première sous-couche de chaque bicouche est choisie pour ne pas favoriser une résonance dans la cavité formée par chaque première sous-couche. Une épaisseur $d_{301}$ permettant une résonance est par exemple $\lambda/4n_{301}$. L'épaisseur $d_{301}$ de la première sous-couche de ladite est donc comprise dans

$$d_{301} \in \left]0; \frac{\lambda}{4n_{301}}\right[ \cup \left]\frac{(2p+1)\lambda}{4n_{301}}; \frac{(2p+3)\lambda}{4n_{301}}\right[$$

où $\lambda$ est une longueur d'onde dudit au moins un mode stationnaire et $p \in \mathbb{N}$.

Le découplage entre la source et le substrat est réalisé en employant un réflecteur anti-résonant. C'est une caractéristique inattendue pour la personne du métier. En effet, la personne du métier cherchant à employer un réflecteur s'orienterait plutôt vers un réflecteur résonant, tel qu'un miroir de Bragg. La personne du métier connait par exemple les sources lumineuses à cavité verticale, employant des miroirs de Bragg pour réaliser le confinement d'un mode guidé vertical.

De manière inattendu, le réflecteur emploie une bicouche dont les sous-couches présentent des indices optiques supérieurs à l'indice optique effectif vu par le mode stationnaire dans la source. C'est également une caractéristique inattendue pour la personne du métier qui penserait que cela tend à favoriser la transmission du mode vers le substrat plutôt que l'empêcher.

Ainsi, le mode stationnaire n'est pas transmis vers le substrat, même si ce dernier présente un indice optique supérieur à l'indice efficace de la source. De plus, le réflecteur ne requiert pas, pour fonctionner, l'usage d'oxyde ou de nitrure. Le mode stationnaire n'est donc pas absorbé par le réflecteur pour une longueur d'onde supérieure ou égale à 4 µm.

Le réflecteur fournit un moyen d'intégrer une source lumineuse pouvant fonctionner dans une gamme spectrale étendue, telle qu'une source III-V, sur un substrat présentant un fort indice optique, tel qu'un substrat Si.

Le réflecteur anti-résonant diffère également d'un réflecteur résonant, tel qu'un miroir de Bragg, en ce qu'une seule des épaisseurs des sous-couches composant ladite au moins une bicouche est contrainte. Ceci permet de faciliter la fabrication dudit réflecteur anti-résonant.

Avantageusement, la deuxième sous-couche de ladite au moins une bicouche peut être confondue avec le substrat. En d'autres termes, elle est indiscernable du substrat. Elle s'étend par exemple directement contre le substrat et est réalisée dans le même matériau que le substrat.

Préférentiellement, l'épaisseur $d_{301}$ de la première sous-couche de ladite au moins une bicouche est telle que

$$d_{301} \in \left]0; \frac{\lambda-\delta}{4n_{301}}\right[ \cup \left]\frac{(2p+1)\lambda+\delta}{4n_{301}}; \frac{(2p+3)\lambda-\delta}{4n_{301}}\right[$$

où $\lambda$ est une longueur d'onde dudit au moins un mode stationnaire, $p \in$ N et $\delta = \lambda \times 10\%$, de préférence $\delta = \lambda \times 20\%$, voire $\delta = \lambda \times 50\%$.

Selon un développement, l'épaisseur $d_{301}$ de la première sous-couche de ladite au moins une bicouche est

$$d_{301} = \frac{\lambda}{4n_{301}}(2N-1)\left[1 - \frac{n_{\text{eff}}^2}{n_{301}^2} + \frac{\lambda^2}{4n_{301}^2 d_{\text{eff}}^2}\right]^{-1/2}$$

avec $N \in$ N*, $\lambda$ une longueur d'onde dudit au moins un mode stationnaire et $d_{\text{eff}}$ une épaisseur du mode stationnaire.

Selon une variante, l'épaisseur $d_{301}$ de la première sous-couche de ladite au moins une bicouche est

$$d_{301} \in \left[\frac{p\lambda-\delta}{2n_{301}}; \frac{p\lambda+\delta}{2n_{301}}\right]$$

avec $\delta = \lambda \times 50\%$, de préférence $\delta = \lambda \times 20\%$, voire $\delta = \lambda \times 10\%$.

Avantageusement, le réflecteur anti-résonant comprend une pluralité de bicouches, la deuxième sous-couche d'une première bicouche de la pluralité de bicouches s'étendant contre la première sous-couche d'une deuxième bicouche de la pluralité de bicouches.

Avantageusement, la source comprend une cavité dans laquelle peut s'établir ledit au moins un mode stationnaire du champ électromagnétique, la cavité comprenant une première couche dite « région active » et une deuxième couche dite « couche de cladding inférieure », la région active s'étendant parallèlement au plan et sur la couche de cladding inférieure, la couche de cladding inférieure étant disposée entre la région active et le réflecteur, la région active étant également configurée pour émettre le champ électromagnétique.

Avantageusement, la couche de cladding inférieure est en matériau III-V, tel que l'InP, la première sous-couche de ladite au moins une bicouche étant en Ge et la deuxième sous-couche de ladite au moins une bicouche étant en Si.

Avantageusement, le système comprend une couche de collage séparant la source et le réflecteur, la couche de collage présentant un indice optique $n_5$ tel que $n_5 \leq n_{301}$ et préférentiellement $n_5 < n_{301}$.

Avantageusement, la couche de collage comprend une face, parallèle au plan comprenant un réseau de diffraction, la couche de cladding inférieure s'étendant contre ladite face de la couche de collage, contre le réseau de diffraction.

L'invention concerne également un procédé de fabrication d'un système comprenant les étapes suivantes:

- former, à partir d'un substrat s'étendant parallèlement à un plan et présentant un indice optique $n_2$ inférieure à un indice effectif $n_{\text{eff}}$, un réflecteur anti-résonant pour au moins un mode stationnaire parallèle au plan d'un champ électromagnétique, ledit réflecteur s'étendant sur le substrat, le réflecteur comprenant au moins une bicouche semiconductrice s'étendant parallèlement au plan, ladite au moins une bicouche comprenant : une première sous-couche semiconductrice et une deuxième sous-couche semiconductrice s'étendant contre la première sous-couche, la deuxième sous-couche étant disposée entre la première sous-couche et le substrat, les première et deuxième sous-couches présentant respectivement des indices optiques $n_{301}$ et $n_{302}$ tels que $n_{301} > n_{302}$ et $n_{301} > n_{\text{eff}}$, la première sous-couche présentant également une épaisseur $d_{301}$ configurée pour former une cavité anti-résonante pour ledit au moins un mode stationnaire ; et

- former, sur le réflecteur, une source lumineuse configurée pour présenter ledit au moins un mode stationnaire parallèle au plan du champ électromagnétique, la source étant également configurée pour présenter, pour ledit au moins un mode stationnaire, l'indice optique effectif $n_{eff}$ tel que $n_{eff} < n_2$.

L'invention et ses différentes applications seront mieux comprises à la lecture de la description qui suit et à l'examen des figures qui l'accompagnent.

## BRÈVE DESCRIPTION DES FIGURES

Les figures sont présentées à titre indicatif et nullement limitatif de l'invention. Sauf précision contraire, un même élément apparaissant sur des figures différentes présente une référence unique.

La [Fig. 1] montre un premier mode de réalisation d'un système selon l'invention.

Les [Fig. 2], [Fig. 3], [Fig. 4] et [Fig. 5] présentent des premiers résultats de simulation numérique réalisés à partir d'un deuxième mode de réalisation du système selon l'invention.

Les [Fig. 6], [Fig. 7], [Fig. 8] et [Fig. 9] présentent des deuxièmes résultats de simulation numérique réalisés à partir d'un système selon l'art antérieur.

Les [Fig. 10] et [Fig. 11] présentent des troisièmes résultats de simulation numérique réalisés à partir d'un troisième mode de réalisation du système selon l'invention.

La [Fig. 12] présente un quatrième résultat de simulation numérique réalisés à partir d'un système comprenant un miroir de Bragg à la place d'un réflecteur selon l'invention.

La [Fig. 13] montre un mode de mise en œuvre d'un procédé de fabrication du système selon l'invention.

## DESCRIPTION DÉTAILLÉE

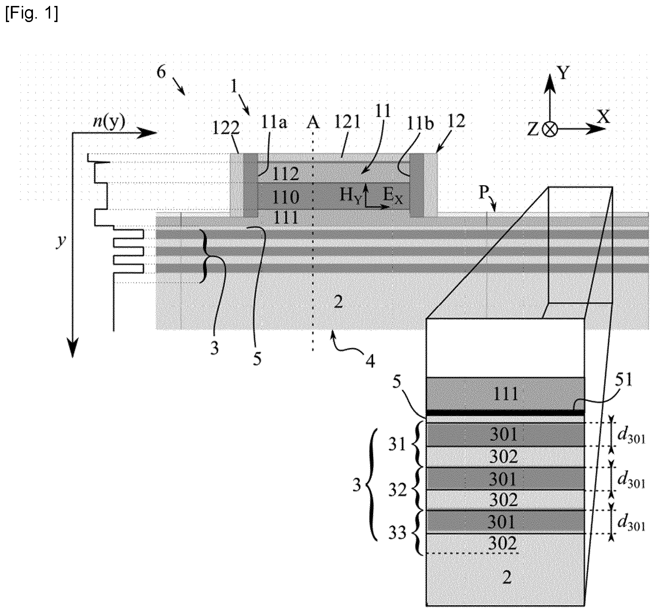

La figure 1 montre un premier mode de réalisation d'un système 6 selon l'invention. Elle montre également un agrandissement d'une portion du système 6 ainsi qu'une courbe d'indice optique n(y) en fonction d'une profondeur *y*. Elle montre en outre un repère orthonormé {X ; Y ; Z}.
Le système 6 comprend une source 1 lumineuse, un substrat 2 et un réflecteur 3.
Le substrat 2 s'étendant parallèlement à un plan P. Par rapport au repère orthonormé {X ; Y ; Z}, le plan P correspond au plan {X ; Z}. La figure 1 ne représente qu'une portion du substrat 2. Ce dernier pouvant être massif, il peut présenter des dimensions très grandes par rapport aux autres éléments du système 6. Le substrat 2 est par exemple en silicium.
Par source 1 lumineuse, ou simplement source 1, on entend une source de rayonnement électromagnétique. Il s'agit par exemple d'une source laser ou d'une source électroluminescente. La source 1 est avantageusement configurée pour réaliser une émission d'un faisceau lumineux dans une gamme de longueurs d'ondes comprise entre 0,8 μm et 20 μm. Cette gamme comprend par exemple l'infrarouge proche et une partie de l'infrarouge moyen. L'émission peut être réalisée par une surface latérale de la source 1 ou par une surface parallèle au plan P. Dans ce premier cas, la source 1 est dite « à émission latérale » tandis que dans le dernier cas, la source 1 est dire « à émission de surface ».
Dans le mode de réalisation de la figure 1, la source 1 présente une forme de crête, dite « ridge » en anglais, s'étirant selon la direction Z. Autrement dit, elle présente un rapport d'aspect important avec une longueur, mesurée selon Z, supérieure à 200 μm et une largeur, mesurée selon X, inférieure à 50 μm. La source 1 peut présenter une hauteur, mesurée selon Y, inférieure à 20 μm, voire inférieure à 10 μm.
La source 1 est configurée pour émettre un champ électromagnétique et confiner ce champ électromagnétique dans un ou plusieurs modes stationnaires. Il peut s'agir de modes stationnaires, tels que ceux observables dans une cavité laser. La source est particulière en ce que chaque mode stationnaire est parallèle au plan P. Par mode parallèle au plan, on entend que le champ présente, de manière exclusive :

- une polarisation du champ électrique perpendiculaire au plan P ; ou

- une polarisation du champ magnétique perpendiculaire au plan P.

On entend que le champ ne présente pas les deux polarisations (du champ électrique et du champ magnétique) qui soient toutes deux sensiblement parallèle au plan P (c'est-à-dire parallèle à 10° près, voire 5° près). Dans le mode parallèle au plan P, on entend que le mode est par exemple transverse au plan P. Autrement dit, le champ électromagnétique comprend par exemple :

- une polarisation du champ électrique normale au plan (c'est à dire parallèle à la direction Y) et une polarisation du champ magnétique parallèle au plan P ; ou

- une polarisation du champ électrique $E_x$ parallèle au plan P et une polarisation du champ magnétique $H_Y$ normale au plan P (telle qu'illustré dans la figure 1).

Sauf mention contraire, un seul mode stationnaire du champ dans la source 1 sera considéré, afin de simplifier la description de l'invention. Les enseignements s'appliquent toutefois à chaque mode stationnaire lorsque la source 1 présente une pluralité de modes stationnaires.

Différentes couches 110, 111, 112 composants la source 1 peuvent présenter des indices optiques différents. Un exemple est reporté sur la courbe d'indice optique n(y). Les différents indices reportés sont considérés le long de la ligne pointillée A. Toutefois, chaque mode stationnaire dans la source 1 peut voir un indice optique effectif $n_{eff}$ qui peut présenter une valeur différente des indices optiques des couches de la source 1, notamment en raison de la géométrie des différentes couches. C'est la raison pour laquelle l'indice optique effectif $n_{eff}$ du mode stationnaire est considéré. L'indice optique effectif $n_{eff}$ peut être déterminé numériquement. Une estimation de l'indice optique effectif $n_{eff}$ peut être déterminée à partir de l'indice optique moyen dans la source 1, calculé le long de la ligne A. Il est également préférable de prendre en compte les éléments permettant de réaliser le confinement du champ électrique dans la source 1, tels que la géométrie (épaisseur et/ou largeur) des autres couches semiconductrices dites « de cladding » ou la présence de couches réflectrices (telles que des électrodes métalliques ou un réseau de diffraction).

Le substrat 2 présente un indice optique $n_2$. Lorsque $n_{eff} > n_2$, le mode stationnaire de la source 1 n'est pas susceptible de se coupler avec le substrat 2. En revanche, lorsque $n_{eff} < n_2$, le mode stationnaire est susceptible de se coupler avec le substrat 2, augmentant les pertes optiques et réduisant l'efficacité de la source 1.

Afin d'éviter cet inconvénient, l'invention prévoit que le réflecteur 3 soit disposé entre le substrat 2 et la source 1. Le réflecteur 3 est particulier en ce qu'il est configuré pour être anti-résonant à au moins un mode stationnaire de la source 1 et préférentiellement tous les modes stationnaires de la source 1. De cette manière, les la transmission des modes stationnaires vers le substrat 2 est réduite et l'efficacité de la source 1 est conservée, quand bien même le substrat 2 montrerait un indice optique fort lui permettant de se coupler avec les modes stationnaires de la source. 1.

Le réflecteur 3 comprend par exemple au moins une cavité optique configurée de manière à être anti-résonante au mode stationnaire. La cavité optique, s'étendant parallèlement au plan P et entre la source 1 et le substrat 2, empêche la transmission du mode stationnaire vers le substrat 2. La source 1 est entièrement superposée, selon la direction normale au plan P, au réflecteur 3. Ainsi, le réflecteur 3 s'étend sous la source 1, au-delà de la source 1, de manière à bloquer efficacement le transfert du mode stationnaire vers le substrat 2.

Dans la figure 1, le réflecteur 3 comprend trois bicouches 31, 32, 33 semiconductrices, s'étendant chacune parallèlement au plan P. Chaque bicouche 31, 32, 33 comprend une première sous-couche 301 semiconductrice et une deuxième sous-couche 302 semiconductrice. La figure 1 montre un agrandissement du réflecteur et d'une portion du substrat 2. Pour chaque bicouche 31, 32, 33, la première sous-couche 301 s'étend contre la deuxième sous-couches 302. Chaque bicouche 31, 32, 33 est orientée de sorte que la première sous-couche 301 soit disposée entre la deuxième sous-couche 302 et la source 1. Une seule bicouche 31 peut suffire pour former la cavité optique non résonante. Toutefois, il est avantageux de disposer d'une pluralité de bicouches 31, 32, 33 (et donc d'une pluralité de cavités anti-résonantes) pour améliorer le découplage entre la source 1 et le substrat 2. Dans le cas de plusieurs bicouches 31, 32, 33, lesdites bicouches sont préférentiellement en contact deux à deux, c'est-à-dire empilée directement l'une sur l'autre, de manière à former un empilement vertical de bicouches 31, 32, 33.

Dans le mode de réalisation de la figure 1, la deuxième sous-couche 302 de l'une 33 des bicouches se confond avec le substrat 2. En effet, il peut être avantageux, pour simplifier la fabrication, que l'une des deuxièmes sous-couches 302 soit une portion du substrat 2.

Afin de former une cavité optique, chaque première sous-couche 301 présente un indice optique $n_{301}$ strictement supérieur à l'indice optique $n_{302}$ de la deuxième sous-couche 302 ou des deuxièmes sous-couches avec lesquelles elle est en contact.

Pour chaque bicouche 31, 32, 33, l'indice optique $n_{301}$ de la première sous-couche 301 est strictement supérieur à l'indice optique $n_{302}$ de la deuxième sous-couche 302. Autrement, pour chaque bicouche 31, 32, 33, les indices optiques vérifient $n_{301} > n_{302}$.

La courbe d'indice optique n(y) de la figure 1 montre un exemple d'alternance pour les indices optiques $n_{301}$, $n_{302}$ des première et deuxième sous-couches 301, 302. Il s'agit en l'occurrence d'un mode de réalisation simple du réflecteur 3 dans lequel les premières sous-couches 301 présentent toutes le même indice optique $n_{301}$. De la même manière, les deuxièmes sous-couches 302 présentent également le même indice optique $n_{302}$.

En l'occurrence, dans cet exemple, les première sous-couches 301 peuvent être réalisées en germanium et les deuxième sous-couches 302 peuvent être réalisées en silicium. Ce mode de réalisation est d'autant plus avantageux lorsque le substrat 2 est également en silicium. Ainsi, une des deuxièmes sous-couches 302 peut être confondu avec le substrat 2.

La première bicouche 31 disposée au voisinage de la source 1 est en interaction directe avec le mode stationnaire dans la source 1. La condition d'anti-résonance impose que sa première sous-couche 301 présente un indice optique $n_{301}$ strictement supérieur à l'indice optique effective $n_{\text{eff}}$ associé au mode stationnaire. Autrement, pour chaque bicouche 31, 32, 33, $n_{301} > n_{\text{eff}}$.

Ainsi, les première sous-couche 301, présentant un indice $n_{301} > n_{\text{eff}}$ et $n_{301} > n_{302}$ forment une pluralité de cavités optiques.

La condition d'anti-résonance peut être obtenue en contrôlant l'épaisseur $d_{301}$ de chaque première sous-couche 301, mesurée perpendiculairement au plan P, autrement dit, l'épaisseur de chaque cavité anti-résonante selon une direction perpendiculaire au mode stationnaire dans la source. L'épaisseur $d_{301}$ peut être fonction de la longueur d'onde $\lambda$ du mode stationnaire de la source 1. $\lambda$ est par exemple compris entre $0,8\ \mu$m et $20\ \mu$m. La longueur d'onde $\lambda$ correspond par exemple à une amplitude maximale du champ électromagnétique dans le mode stationnaire. Elle peut être fixée par la source 1 selon le mode stationnaire établi.

Par exemple, l'épaisseur $d_{301}$ de chaque première sous-couche 301 peut être telle que

$$d_{301} \in \left]0;\ \frac{\lambda}{4n_{301}}\right[ \cup \left]\frac{(2p+1)\lambda}{4n_{301}};\ \frac{(2p+3)\lambda}{4n_{301}}\right[$$

où p $\in$ N et $\cup$ est l'opérateur d'union.

L'épaisseur $d_{301}$ de la première sous-couche 301 peut prendre une valeur différente de $\lambda/4n_{301}$, cette valeur favorisant une résonance du mode dans les premières sous-couches. En effet, une épaisseur, par exemple égale à $d_{301} = (2p + 1)\lambda/4n_{301}$, favoriserait le transfert du mode stationnaire à travers le réflecteur 3 et réduirait donc l'efficacité de la source 1.

Afin d'optimiser l'anti-résonance du réflecteur 3, chaque première sous-couche 301 présente avantageusement une épaisseur $d_{301}$ telle que

$$d_{301} \in \left]0;\ \frac{\lambda-\delta}{4n_{301}}\right[ \cup \left]\frac{(2p+1)\lambda+\delta}{4n_{301}};\ \frac{(2p+3)\lambda-\delta}{4n_{301}}\right[$$

où $\delta$ = 10% $\lambda$. Ainsi, les épaisseurs $d_{301}$ des premières sous-couches 301 présentent des valeurs éloignées de $(2p + 1)\lambda/4n_{301}$ afin de limiter la résonance du mode dans les premières sous-couches 301 et découpler ainsi le mode stationnaire du substrat 2. De manière préférée, $\delta$ = 20% $\lambda$, voire $\delta$ = 50% $\lambda$.

L'épaisseur $d_{301}$ peut être ajustée dans l'intervalle précédent en réalisant une optimisation, par exemple numérique, cherchant à minimiser la transmission du mode stationnaire vers le substrat 2.

Dans un mode de réalisation, l'épaisseur $d_{301}$ peut être comprise dans

$$d_{301} \in \left[\frac{p\lambda-\delta}{2n_{301}};\ \frac{p\lambda+\delta}{2n_{301}}\right]$$

Par exemple, l'épaisseur $d_{301}$ peut être égale à

$$d_{301} = \frac{p\lambda}{2n_{301}}$$

Il s'agit d'une épaisseur qui est l'exact opposé de l'épaisseur pouvant être mis en œuvre dans un réflecteur résonant tel qu'un réflecteur de Bragg.

Dans un mode de réalisation préféré, l'épaisseur $d_{301}$ est :

$$d_{301} = \frac{\lambda}{4n_{301}}(2N-1)\left[1 - \frac{n_{\text{eff}}^2}{n_{301}^2} + \frac{\lambda^2}{4n_{301}^2 d_{\text{eff}}^2}\right]^{-1/2}$$

où $N \in \mathbb{N}^*$, $d_{\text{eff}}$ et $n_{\text{eff}}$ sont respectivement une épaisseur effective du mode stationnaire dans la source 1 et l'indice optique effectif vu par le mode stationnaire dans la source 1. L'épaisseur effective $d_{\text{eff}}$ du mode correspond à une épaisseur que le mode stationnaire présente dans la source 1. Elle correspond par exemple à une épaisseur $d_{11}$ d'une cavité 11 de la source 1 dans laquelle s'établit le mode stationnaire. L'indice effectif $n_{\text{eff}}$ peut être déterminé à partir des indices optiques des éléments composants la cavité 11 dans laquelle s'est établi le mode stationnaire. L'indice effectif $n_{\text{eff}}$ peut être égal à la moyenne des indices optiques des constituants de la cavité 11.

Dans le mode de réalisation de la figure 1, la source 1 est une source laser. Elle comprend une cavité laser 11 configurée pour émettre un champ électromagnétique et confiner ce champ électromagnétique dans un mode stationnaire. La cavité 11 s'étend parallèlement au plan P. Elle présente par exemple une largeur, mesurée selon la direction X, parallèle au plan (et dans le plan de la figure 1) compris entre 2 et 50 µm. Elle peut en outre présenter une hauteur, que l'on appellera également épaisseur $d_{11}$, mesurée perpendiculairement au plan P, comprise entre 2 µm et 10 µm. Elle peut également présenter une longueur, mesurée selon la direction Z, comprise entre 20 µm et 1000 µm, voire entre 100 µm et 5000 µm (il s'agit d'un laser de type « ridge »).

Dans le mode de réalisation de la figure 1, la source 1 comprend une cavité 11 dans laquelle peut s'établir le ou les modes stationnaires. La cavité 11 comprend une pluralité de couches s'étendant parallèlement au plan P. La cavité 11 comprend par exemple une première couche 110, que l'on nomme « région active » ou « région amplificatrice ». La région active 110 est configurée pour émettre le champ électromagnétique. La cavité 11 comprend également une deuxième couche semiconductrice 111, dite « couche de cladding inférieure », s'étendant entre la région active 110 et le réflecteur 3. La région active 110 repose sur la couche de cladding intérieure 111. La cavité 11 comprend également une troisième couche semiconductrice 112, dites « couches de cladding supérieure », reposant sur la région active 110. La région active 110 sépare les couches de cladding 111, 112. Les trois couches forment ainsi un empilement vertical. Ledit empilement est délimité par un ou plusieurs flancs 11a, 11b de sorte que les trois couches précitées 110, 111, 112 soient à l'aplomb l'une de l'autre.

La région active 110 peut être configurée pour que l'émission du champ électromagnétique soit au moins spontanée et préférentiellement spontanée et stimulée. Ce dernier cas permet un fonctionnement en mode laser de la source 1. L'émission peut être basée sur l'émission inter-bandes également appelée « interband cascade emission » en anglais. Elle peut être préférentiellement basée sur l'émission inter-sous bandes également appelée « émission à cascade quantique » ou « quantum cascade emission » en anglais. Pour permettre une émission à cascade quantique, la région active 110 comprend par exemple un empilement de sous-couches en matériau III-V, formant une succession de puits quantiques et de barrières de potentiel. L'empilement de sous-couches s'étend par exemple parallèlement au plan P.

Les couches de cladding 111, 112 permettent de contribuer au confinement du champ électromagnétique dans la cavité 11, notamment selon la direction Y, normale au plan. De la sorte, le champ électromagnétique reste localisé au niveau de la région active 110 et permet par exemple de favoriser l'émission stimulée de la région active 110. Pour cela, les couches de cladding 111, 112 sont par exemple configurées pour présenter des indices optiques $n_{111}$, $n_{112}$ strictement inférieurs à un indice optique moyen $n_{110}$ de la région active 110. Par indice optique moyen $n_{110}$ de la région active 110, on entend un indice optique prenant en compte les indices des couches ou sous-couches composant la région active 110. De la sorte, le champ électromagnétique émis par la région active 110 est confiné au voisinage de la région active 110.

Les indices optiques $n_{111}$, $n_{112}$ et $n_{110}$ des couches de cladding 111, 112 et de la région active 110 sont reportés sur la courbe d'indice $n(y)$.

Afin d'activer l'émission spontanée de la région active 110, la source 1 comprend des moyens pour faire circuler un courant électrique dans la région active 110. Ces moyens comprennent par exemple les couches de cladding 111, 112 lorsque ces dernières sont dopées. Elles permettent ainsi la conduction du courant électrique à travers la région active 110.

La source 1 peut également comprendre des électrodes 12 conductrices permettant la circulation du courant électrique dans les couches de cladding 111, 112 et en particulier dans la région active 110. Une première électrode 121 conductrice, par exemple en Au ou Ti, s'étend au contact de la couche de cladding supérieur 112 (si cette dernière est dopée) de manière à établir un contact électrique. De manière similaire, deux deuxièmes électrodes 122 conductrices, par exemple en Au ou Ti, s'étendent contre une portion de la couche de cladding inférieure 111 de manière à établir un contact électrique. Les deux deuxièmes électrodes 122 s'étendent également parallèlement aux flancs 11a, 11b de la cavité 11. Pour éviter que les couches de cladding 111, 112 et la région active 110 ne soient court-circuitées par les deuxièmes électrodes 122, la source 1 comprend également deux espaceurs isolants, par exemple en SiN, disposés entre la cavité 11 et chaque deuxième électrode 122. Les espaceurs s'étendent par exemple au contact de chaque flanc 11a, 11b de la cavité 11 et séparent la cavité 11 des deuxièmes électrodes 122.

Lorsque la source 1 est une source de type III-V. Les couches de cladding 111, 112 sont par exemple en alliage III-V tel que l'InP. La région active 110 comprend par exemple une multicouches de InGaAs/AllnAs ou de InAlAs/AlGaInAs. Pour intégrer la source III-V sur le substrat 2 en Si, chaque première sous-couche 301 du réflecteur 3 peut être en Ge et chaque deuxième sous-couche 302 du réflecteur 3 peut être en Si.

En effet, il est aisé de réaliser une alternance de sous-couches Si et Ge à partir d'un substrat Si massif, par exemple par croissance. De plus, ces croissances peuvent être réaliser avec des moyens standards mis en œuvre dans la technologie dite « CMOS » pour « Complementary Metal-Oxide-Semiconductor » en anglais.

Afin de faciliter le report de la source 1 sur le réflecteur 3, le système 6 peut comprendre une couche de collage 5, disposée entre la source 1 et le réflecteur 3. La couche de collage 5 s'étend d'ailleurs préférentiellement au contact du réflecteur 3, la source 1 reposant directement sur la couche de collage 5. Par « couche de collage », on entend une couche dont la fonction est de permettre le report, également appelé collage sur le réflecteur 3. En effet, il peut être difficile de réaliser le report d'une couche en matériau III-V (telle que la couche de cladding inférieure 111) directement sur une couche en Ge. La couche de collage 5 est donc réalisée dans un matériau qui facilite, d'une part, le report de la source 1 sur celle-ci et, d'autre part, n'interfère pas négativement avec le réflecteur 3 ou avec le mode stationnaire dans la source 1.

Dans le mode de réalisation illustré, la couche de collage 5 s'étend sur une première sous-couche 301 du réflecteur 3. Afin de ne pas interférer, la couche de collage 5 présente préférentiellement un indice optique $n_5$ tel que $n_5 < n_{301}$. Ainsi, la deuxième sous-couche 301 du réflecteur 3 qui est en contact avec la couche de collage 5 peut jouer son rôle de cavité optique. De manière préférée, $n_5 \leq n_{302}$. Il peut être avantageux que $n_5 \leq n_{eff}$, toutefois il est attendu que la couche de collage 5 ne soit pas réalisée dans un matériau, telle qu'un oxyde ou un nitrure, qui puisse absorber le mode stationnaire lorsqu'il appartient à une gamme de longueurs d'onde supérieure à 4 $\mu$m. Ains, une couche de collage 5 présentant un indice $n_5$ satisfaisant $n_{eff} \leq n_5 \leq n_{302}$ offre un bon compromis. Par exemple la couche de collage 5 peut être réalisée avec le même matériau que les deuxièmes sous-couches 302 du réflecteur 3, tel que le Si.

La source 1 peut être une source laser à contre-réaction répartie, appelée DFB pour « distributed feedback » en anglais. Dans une source DFB, le mode stationnaire s'établi dans une cavité, en réponse à l'action d'un réseau de diffraction s'étendant sur une face de ladite cavité. Dans le cas de la source 1, le réseau de diffraction s'étend sur une des faces de la cavité 11 et selon la direction Z. Ainsi, le mode stationnaire s'établit dans la cavité 11, selon la direction Z.

Le réseau de diffraction s'étend par exemple sur la couche de cladding supérieur 112. Le réseau de diffraction s'étend par exemple sur une face d'une des couches de cladding 111, 112, ladite face étant opposée à la région active 110. Selon un premier exemple, le réseau de diffraction s'étend sur une face de la couche de cladding supérieure 112, entre ladite couche 112 et l'électrode supérieure 121 s'étendant sur la cavité 11. Dans un développement, le réseau de diffraction peut être gravé dans la face de ladite couche de cladding supérieure 112. Le réseau de diffraction est par exemple formé par des tranchées, orientées selon la direction X, et espacées avec un pas constant selon la direction Z.

Selon une variante, le réseau de diffraction s'étend sur la couche de cladding inférieure 111. Il s'étend par exemple sur une face de la couche de cladding inférieure 111, entre ladite couche 111 et la couche de collage 5. Le réseau de diffraction peut être gravé dans la face de ladite couche de cladding inférieure 111. De manière alternative, le réseau de diffraction peut être formé dans la couche de collage 5, par exemple gravé dans cette dernière.

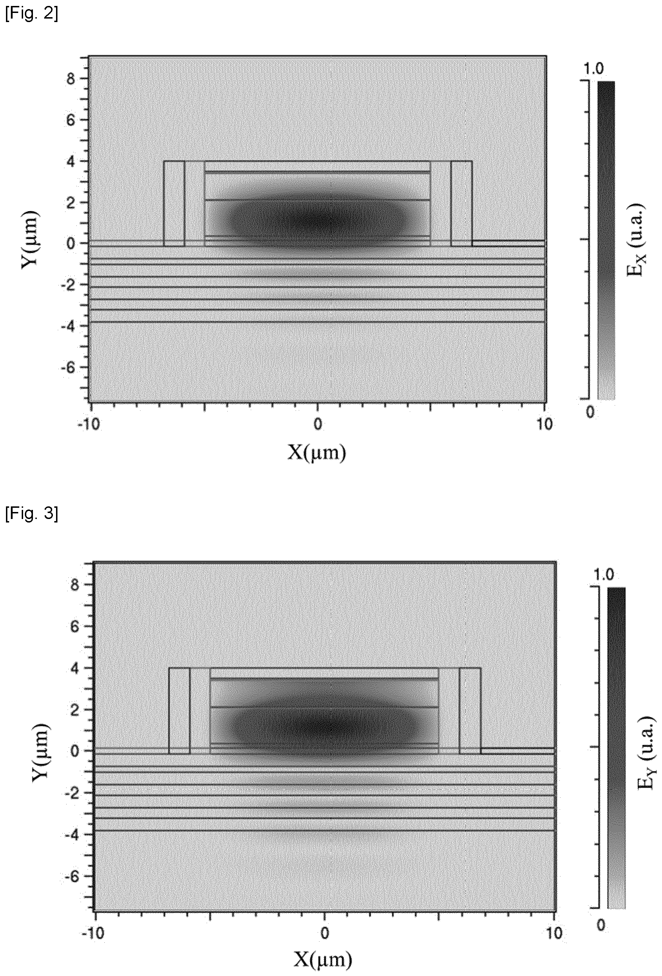

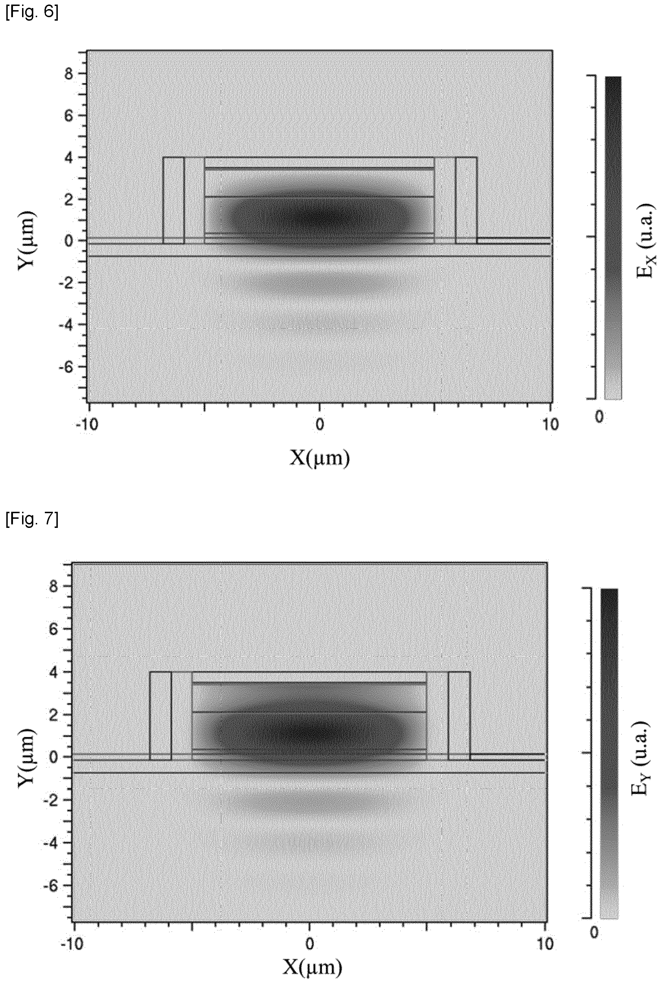

Les figures 2 à 13 présentent des résultats de simulations numériques réalisés en considérant plusieurs modes de réalisation du réflecteur 3. Les figures 6 à 9 sont d'ailleurs réalisées à partir d'un réflecteur selon l'art antérieur.

Toutes les simulations ont été réalisées avec une même source 1. Elle comprend une cavité 11 telle que décrite en référence à la figure 1. La cavité présente une largeur, mesurée selon X, de 10 $\mu$m et une hauteur, mesurée selon Y, de 3 $\mu$m. La cavité 11 présente une longueur, mesurée selon Z, de 250 $\mu$m.

La couche de cladding inférieure 111 est réalisée en InP et présente une épaisseur de 0,6 $\mu$m (sauf indication contraire, les épaisseurs indiquées sont mesurées perpendiculairement au plan P). La région active 110 présente une épaisseur de 1,72 $\mu$m. La couche de cladding supérieure 112 est réalisée en InP et présente une épaisseur de 1,3 $\mu$m. Une couche en InGaAs sépare la région active 110 de la couche de cladding inférieure 111. Elle présente une épaisseur de 0,3 $\mu$m. Une couche en InP sépare cette couche en InGaAs de la région active 110 et présente une épaisseur de 0,2 $\mu$m. Une couche en InGaAs sépare également la région active de la couche de cladding supérieure 112. Elle présente une épaisseur de 0,02 $\mu$m. Une couche en InGaAs de 0,1 $\mu$m sépare la couche de cladding supérieure de la première électrode conductrice 121. Cette électrode 121 est en Au et présente une épaisseur de 0,5 $\mu$m. Les deuxièmes électrodes conductrices 122 s'étendant au regard des flancs de la cavité 11 sont également en Au et présentent des épaisseurs, mesurées parallèlement au plan P, de 0,9 $\mu$m. Un espaceur en SiN sépare chaque deuxième électrode 122 de la cavité 11. L'espaceur présente une épaisseur, également mesurée parallèlement au plan P, de 0,9 $\mu$m.

Le substrat 2 est en Si.

Le mode stationnaire établi dans la cavité 11 est monochromatique et présente une longueur d'onde de 4,5 $\mu$m. L'indice optique du Si est 3,47. L'indice optique du Ge est 4. L'indice optique de l'InP est 3,11. L'indice optique moyen de la région active 110 est 3,35.

Les figures 2 à 5 présentent des premiers résultats de simulation numérique réalisés à partir d'un premier mode de réalisation du réflecteur 3. Le réflecteur 3 comprend un empilement de trois bicouches 31, 32, 33. L'empilement s'étend sur le substrat 2. Les premières sous-couches 301 sont en Ge et les deuxièmes sous-couches 302 sont en Si. Les premières sous-couches 301 présentent chacune une épaisseur $d_{301}$ = 0,496 $\mu$m. Les deuxièmes sous-couches 302 présentent chacune une épaisseur, mesurées perpendiculairement au plan, de 0,607 $\mu$m.

La bicouche s'étendant directement contre le substrat 2 comprend une deuxième sous-couche 302 qui est indiscernable du substrat 2.

Le système comprend également une couche de collage 5, en Si, présentant une épaisseur de 0,255 $\mu$m. La couche de collage 5 s'étend directement contre le réflecteur 3 (et en l'occurrence sur une sous-couche en Ge) et la source 1 (et plus particulièrement la couche de cladding inférieure 111) s'étend contre la couche de collage 5.

Les dimensions du réflecteur 3, et en particulier les première et deuxièmes sous-couches 301, 302, ont été déterminées au moyen d'un algorithme d'optimisation. L'algorithme est d'ailleurs basé sur une optimisation génétique. Le critère d'optimisation minimisé est proportionnel aux pertes optiques du mode stationnaire dans le substrat 2. Il s'agit en l'occurrence de la partie imaginaire de l'indice optique effectif du mode stationnaire.

Les figures 2 et 3 montrent, en niveau de gris, une amplitude du champ électrique selon, respectivement, la direction X (parallèle au plan P) et la direction Y (normale au plan P). En d'autres termes, la figure 2 montre l'amplitude du champ électrique pour un mode TE$_{00}$ et la figure 3 montre l'amplitude du champ électrique pour un mode TM$_{00}$.

Les figures 2 et 3 montrent que les modes considérés sont confinés dans la cavité 11. Ils s'étendent d'ailleurs peu, voire pas, dans le réflecteur 3, et de manière négligeable dans le substrat 2.

La partie imaginaire Im($n_{\text{eff}}$) de l'indice optique effectif du mode stationnaire dans la cavité 11 est proportionnelle aux pertes subit par le mode stationnaire. Elle est donc proportionnelle à son niveau de couplage avec le substrat 2.

Pour les figures 2 et 3, Im($n_{\text{eff}}$) est respectivement égale à $0,6 \times 10^{-3}$ et $2 \times 10^{-3}$.

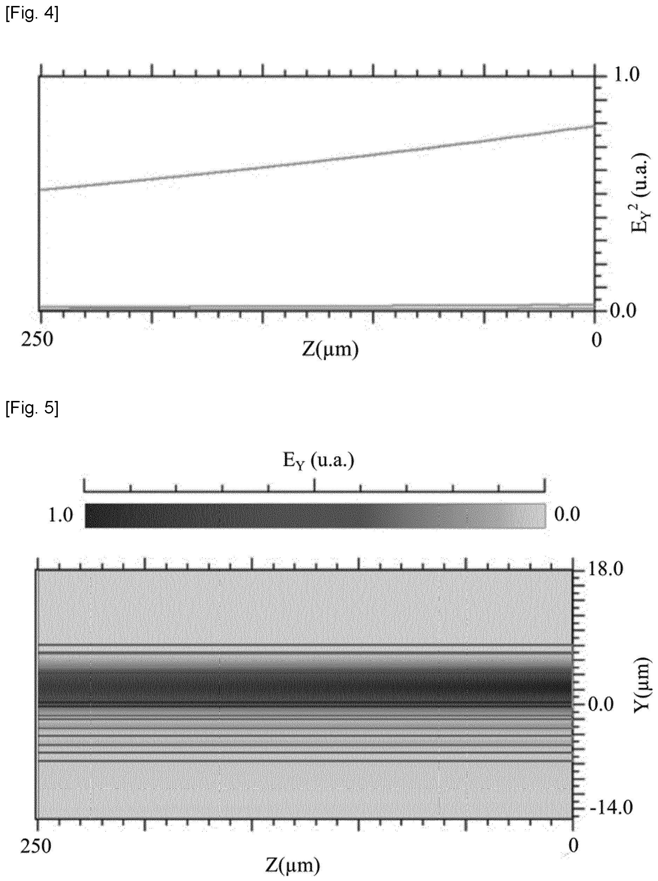

Les figures 4 et 5 montrent la propagation d'une onde TM$_{00}$ dans la cavité 11 et en particulier le long de la direction Z, selon laquelle s'étend la cavité 11. Le mode considéré n'est pas stationnaire mais propagatif. Il permet toutefois de visualiser l'effet du réflecteur 3 sur la propagation du champ dans le système 6. L'onde est générée en Z = 0 $\mu$m et se propage sur 250 $\mu$m.

L'amplitude du champ $E_Y$ est matérialisée en niveau de gris dans la figure 5. La puissance correspondante est reportée dans la figure 4. On voit sur la figure 5 que l'amplitude du champ décroit à mesure que l'onde se propage selon Z. La perte de puissance, illustrée sur la figure 4, est inférieure à 40 %.

À titre comparatif, les figures 6 à 9 présentent des résultats de simulation numérique réalisés à partir d'un système 6 comprenant, en lieu et place du réflecteur 3, une couche d'oxyde, tel qu'enseigné par l'art antérieur.

Les figures 6 et 7 montrent également, en niveau de gris, une amplitude du champ électrique de modes TE$_{00}$ et TM$_{00}$.

À la différence des figures 2 et 3, le confinement est moins efficace avec la couche d'oxyde. Les modes stationnaires s'étendent de manière significative au-delà de la cavité 11 et de la couche d'oxyde, jusque dans le substrat 2. Le résultat est particulièrement significatif pour le mode TM$_{00}$ de la figure 7.

Pour les figures 6 et 7, Im($n_{\text{eff}}$) est respectivement égale à $4 \times 10^{-3}$ et $4 \times 10^{-3}$. La partie imaginaire est donc significativement plus élevée. Le réflecteur 3 réduit donc les pertes optiques du mode stationnaire.

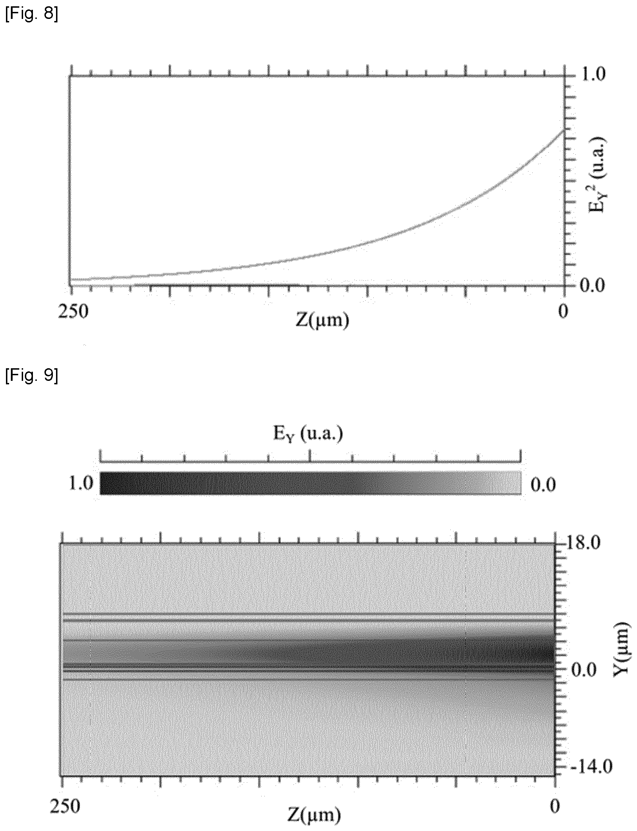

Les figures 8 et 9 montrent la propagation d'une onde TM$_{00}$ dans la cavité 11 découplée du substrat 2 au moyen de la couche d'oxyde.

L'amplitude du champ $E_Y$ est matérialisée en niveau de gris dans la figure 9. La puissance correspondante est reportée dans la figure 8. La figure 9 montre que l'amplitude du champ décroit rapidement à mesure que l'onde se propage selon Z. La perte de puissance, illustrée sur la figure 8, est drastique puisque proche de 100 % pour Z = 250 $\mu$m.

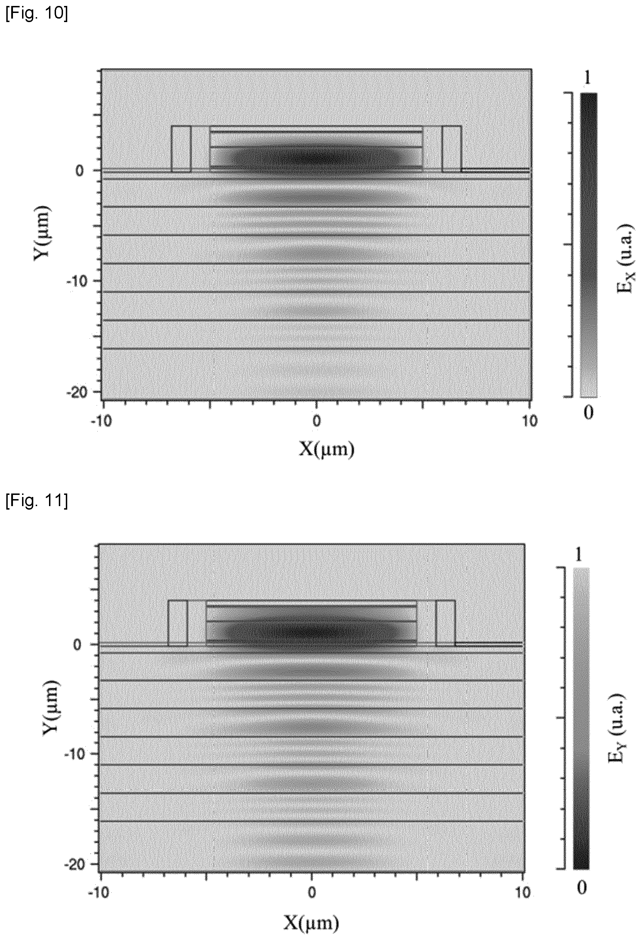

Les figures 10 et 11 présentent des résultats de simulation numérique réalisés à partir d'un deuxième mode de réalisation du réflecteur 3. À la différence du mode de réalisation des figures 2 à 5, l'épaisseur $d_{301}$ de chaque première sous-couche 301 suit :

$$d_{301} = \frac{\lambda}{4n_{301}}(2N-1)\left[1 - \frac{n_{\text{eff}}^2}{n_{301}^2} + \frac{\lambda^2}{4n_{301}^2 d_{\text{eff}}^2}\right]^{-1/2}$$

En l'occurrence, l'épaisseur de chaque première sous-couche 301 considérée est 2,12 $\mu$m. L'épaisseur de chaque deuxième sous-couche 302 est 2,56 $\mu$m.

Les figures 10 et 11 montrent également, en niveau de gris, une amplitude du champ électrique de modes TE$_{00}$ et TM$_{00}$. Im($n_{\text{eff}}$) est respectivement égale à $0,1 \times 10^{-3}$ et $0,3 \times 10^{-3}$. La partie imaginaire est donc réduite par rapport à celle obtenue au figures 6 et 7. Ainsi, dès lors que le réflecteur 3 est anti-résonant, il réduit significativement les pertes optiques du mode stationnaire.

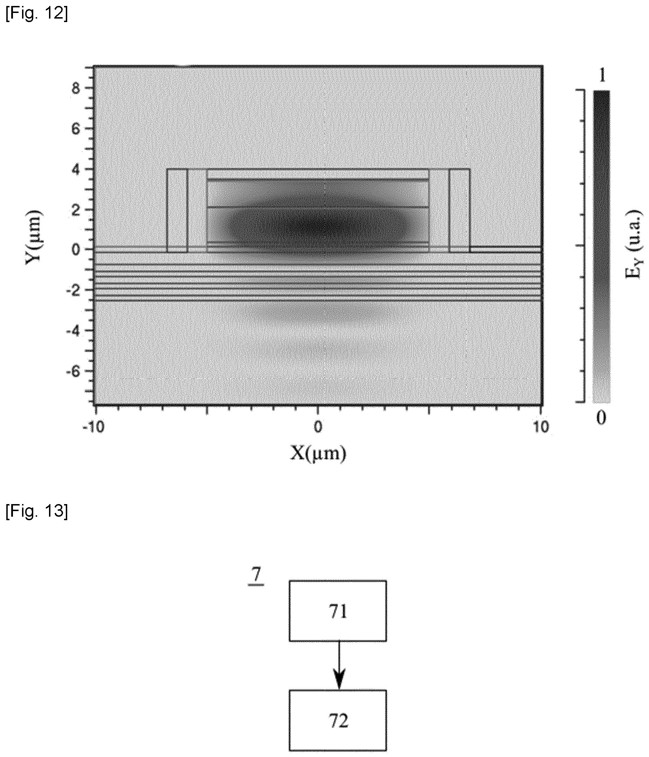

La figure 12 présente, à titre de comparaison, un résultat de simulation numérique obtenu à partir d'un système 6 pour lequel le réflecteur 3 est remplacé par un miroir de Bragg. À la différence du mode de réalisation des figures 2 à 5, les épaisseurs des couches de Si et de Ge sont configurées pour que le miroir soit résonant, au lieu d'être anti-résonant.

La figure 12 montre, en niveau de gris, une amplitude du champ électrique dans un mode $TM_{00}$. La partie imaginaire de l'indice optique effectif $Im(n_{eff})$ est égale à $4 \times 10^{-3}$, ce qui est équivalent à celle obtenue lorsque le réflecteur 3 anti-résonant est remplacé par une couche d'oxyde. Le miroir de Bragg ne présente donc aucun intérêt par rapport à une couche d'oxyde telle que mise en œuvre selon les enseignements de l'art antérieur.

La mise en œuvre d'un réflecteur 3 anti-résonant offre donc un bon moyen de découpler efficacement un mode stationnaire établi dans une source 1 disposée sur un substrat d'indice optique élevé.

La figure 13 montre schématiquement un exemple de mise en œuvre d'un procédé 7 de fabrication du système 6. Le procédé 7 comprend deux étapes majeurs qui sont, la formation 71 du réflecteur 3 et la formation 72 de la source 1 sur le réflecteur 3.

La formation 71 du réflecteur 3 est avantageusement réalisée à partir du substrat 2. Le réflecteur 3 est d'ailleurs formé de préférence en pleine plaque, c'est-à-dire sur la totalité de la surface du substrat 2. D'ailleurs, au terme de la formation du réflecteur 3, le substrat 1 comprend, sur une de ses faces, au moins une bicouche 31, 32, 33, voire une couche de collage 5. L'ensemble du substrat 2 et du réflecteur 3 forme d'ailleurs ce que l'on peut appeler un substrat fonctionnalisé, dans le sens où le substrat 2 est préparé pour recevoir une source 1 telle qu'une source III-V.

La formation 71 du réflecteur 3 comprend par exemple le dépôt des sous-couches et couches successives suivants les enseignements précités. La fabrication de ces couches fait intervenir des méthodes qui sont connues de la personne du métier.

Les caractéristiques de la source 1 et du mode stationnaire sont préférentiellement connues avant la réalisation de la formation 71 du réflecteur 3. De la sorte, les caractéristiques du réflecteur 3, que sont par exemple les indices optiques des bicouches composant le réflecteur 3 ou les épaisseurs des sous-couches composant chaque bicouche, peuvent être déterminées avant leur fabrication. Alternativement, lorsque les caractéristiques de la source 1 et/ou du mode stationnaire ne sont pas connues par avance, le réflecteur 3 peut être formé en considérant un indice optique effective visé et une longueur d'onde visée. De la sorte, le substrat fonctionnalisé peut être fabriqué et l'adéquation entre le réflecteur 3 et la source 1 repose alors sur le choix de cette source 1.

La formation 72 de la source 1 peut faire intervenir une étape de collage, tel qu'un collage moléculaire. Par exemple, la source 1 peut être réalisée de manière distincte du réflecteur 3, par exemple à partir d'un substrat III-V. Elle peut ensuite être reportée sur le substrat fonctionnalisé issu de l'étape de formation 71 du réflecteur 3. Alternativement, la source 1 peut être réalisée directement à partir de la surface libre du réflecteur 3 (ou de la couche de collage 5).

Afin de former une source 1 laser, la couche de collage 5 du substrat fonctionnalisé peut présenter un réseau de diffraction. Le réseau de diffraction est par exemple gravé dans la couche de collage 5 après que cette dernière ait été déposée sur le réflecteur 3. Cette étape de gravure fait avantageusement partie de l'étape de formation du réflecteur 3.

**Revendications**

1. Système (6) comprenant :

   - un substrat (2) s'étendant parallèlement à un plan (P), ledit substrat (2) présentant un indice optique $n_2$ ;
   - une source (1) lumineuse configurée pour présenter au moins un mode stationnaire d'un champ électromagnétique, ledit mode étant parallèle au plan (P), la source (1) étant également configurée pour présenter, pour ledit au moins un mode stationnaire, un indice optique effectif $n_{eff}$ tel que $n_{eff} < n_2$ ;

   le système (6) étant **caractérisé en ce qu'**il comprend également un réflecteur (3) anti-résonant pour ledit au moins un mode stationnaire, ledit réflecteur s'étendant sur le substrat (2) et la source (1) s'étendant sur le réflecteur (3), le réflecteur (3) comprenant au moins une bicouche (31, 32, 33) semiconductrice s'étendant parallèlement au plan (P), ladite au moins une bicouche (31, 32, 33) comprenant : une première sous-couche (301) semiconductrice et une deuxième sous-couche (302) semiconductrice s'étendant contre la première sous-couche (301), la première sous-couche (301) étant disposée entre la source (1) et la deuxième couche-couche (302), les première et deuxième sous-couches (301, 302) présentant respectivement des indices optiques $n_{301}$ et $n_{302}$ tels que $n_{301} > n_{302}$ et $n_{301} > n_{eff}$, la première sous-couche (301) présentant également une épaisseur $d_{301}$ configurée pour former une cavité anti-résonante pour ledit au moins un mode stationnaire.

2. Système (6) selon la revendication précédente, **caractérisé en ce que** l'épaisseur $d_{301}$ de la première sous-couche (301) de ladite au moins une bicouche (31, 32, 33) est telle que

$$d_{301} \in \left]0; \frac{\lambda - \delta}{4n_{301}}\right[ \cup \left]\frac{(2p+1)\lambda + \delta}{4n_{301}}; \frac{(2p+3)\lambda - \delta}{4n_{301}}\right[$$

où $\lambda$ est une longueur d'onde dudit au moins un mode stationnaire, $p \in \mathbb{N}$ et $\delta = \lambda \times 10\%$.

3. Système (6) selon l'une des revendications 1 à 2, **caractérisé en ce que** l'épaisseur $d_{301}$ de la première sous-couche (301) de ladite au moins une bicouche (31, 32, 33) est

$$d_{301} = \frac{\lambda}{4n_{301}}(2N - 1)\left[1 - \frac{n_{eff}^2}{n_{301}^2} + \frac{\lambda^2}{4n_{301}^2 d_{eff}^2}\right]^{-1/2}$$

avec $N \in \mathbb{N}^*$, $\lambda$ une longueur d'onde dudit au moins un mode stationnaire et $d_{eff}$ une épaisseur du mode stationnaire.

4. Système (6) selon l'une des revendications 1 à 2, **caractérisé en ce que** l'épaisseur $d_{301}$ de la première sous-couche (301) de ladite au moins une bicouche (31, 32, 33) est

$$d_{301} \in \left[\frac{p\lambda - \delta}{2n_{301}}; \frac{p\lambda + \delta}{2n_{301}}\right]$$

avec $\delta = \lambda \times 50\%$.

5. Système (6) selon l'une des revendications précédentes, **caractérisé en ce que** le réflecteur anti-résonant (3) comprend une pluralité de bicouches (31, 32, 33), la deuxième sous-couche (302) d'une première bicouche (31) de la pluralité de bicouches (31, 32, 33) s'étendant contre la première sous-couche (301) d'une deuxième bicouche (32) de la pluralité de bicouches (31, 32, 33).

6. Système (6) selon l'une des revendications précédentes, **caractérisé en ce que** la source (1) comprend une cavité (11) dans laquelle peut s'établir ledit au moins un mode stationnaire du champ électromagnétique, la cavité (11) comprenant une première couche (110) dite « région active » et une deuxième couche (111) dite « couche de cladding inférieure », la région active (110) s'étendant parallèlement au plan (P) et sur la couche de cladding inférieure (111), la couche de cladding inférieure (111) étant disposée entre la région active (110) et le réflecteur (3), la région active (110) étant également configurée pour émettre le champ électromagnétique.

7. Système (6) selon la revendication précédente, **caractérisé en ce que** la couche de cladding inférieure (111) est en matériau III-V, tel que l'InP, la première sous-couche (301) de ladite au moins une bicouche (31, 32, 33) étant en Ge et la deuxième sous-couche (302) de ladite au moins une bicouche (31, 32, 33) étant en Si.

8. Système (6) selon l'une des revendications précédentes, **caractérisé en ce qu'**il comprend une couche de collage (5) séparant la source (1) et le réflecteur (3), la couche de collage (5) présentant un indice optique $n_5$ tel que $n_5 \leq n_{301}$.

9. Système (6) selon la revendication précédente et l'une des revendications 6 ou 7, **caractérisé en ce que** la couche de collage (5) comprend une face, parallèle au plan (P) comprenant un réseau de diffraction (51), la couche de cladding inférieure (111) s'étendant contre ladite face de la couche de collage (5), contre le réseau de diffraction (51).

10. Procédé (7) de fabrication d'un système (6) comprenant les étapes suivantes:

- former (71), à partir d'un substrat (2) s'étendant parallèlement à un plan (P) et présentant un indice optique $n_2$ inférieure à un indice effectif $n_{eff}$, un réflecteur (3) anti-résonant pour au moins un mode stationnaire parallèle au plan (P) d'un champ électromagnétique, ledit réflecteur s'étend sur le substrat (2), le réflecteur (3) comprenant au moins une bicouche (31, 32, 33) semiconductrice s'étendant parallèlement au plan (P), ladite au moins une bicouche (31, 32, 33) comprenant : une première sous-couche (301) semiconductrice et une deuxième sous-couche (302) semiconductrice s'étendant contre la première sous-couche (301), la deuxième sous-couche (302) étant disposée entre la première sous-couche (301) et le substrat (2), les première et deuxième sous-couches (301, 302) présentant respectivement des indices optiques $n_{301}$ et $n_{302}$ tels que $n_{301} > n_{302}$ et $n_{301} > n_{eff}$, la première sous-couche (301) présentant également une épaisseur $d_{301}$ configurée pour former une cavité anti-résonante pour ledit au moins un mode stationnaire ; et

- former (72), sur le réflecteur (3), une source (1) lumineuse configurée pour présenter ledit au moins un mode stationnaire parallèle au plan (P) du champ électromagnétique, la source (1) étant également configurée pour présenter, pour ledit au moins un mode stationnaire, l'indice optique effectif $n_{eff}$ tel que $n_{eff} < n_2$.

**Patentansprüche**

1. System (6) bestehend aus:

   - einem Substrat (2), das sich parallel zu einer Ebene (P) erstreckt, wobei das Substrat (2) einen optischen Index $n_2$ aufweist;
   - einer Lichtquelle (1), die so gestaltet ist, dass sie mindestens einen stationären Modus eines elektromagnetischen Feldes aufweist, wobei der Modus parallel zur Ebene (P) ist und die Lichtquelle (1) auch derart gestaltet ist, dass sie für den mindestens einen stationären Modus einen effektiven optischen Index $n_{eff}$ aufweist, so dass $n_{eff} < n_2$;

   wobei das System (6) **dadurch gekennzeichnet ist, dass** es auch einen Antiresonanzreflektor (3) für den mindestens einen stationären Modus umfasst, wobei sich der Reflektor über das Substrat (2) und die Lichtquelle (1) über den Reflektor (3) erstreckt, wobei der Reflektor (3) mindestens eine Halbleiter-Doppelschicht (31, 32, 33) umfasst, die sich parallel zur Ebene (P) erstreckt und die mindestens eine Doppelschicht (31, 32, 33) umfasst: eine erste Halbleiter-Unterschicht (301) und eine zweite Halbleiter-Unterschicht (302), die sich gegen die erste Unterschicht (301) erstreckt, wobei die erste Unterschicht (301) zwischen der Lichtquelle (1) und der zweiten Unterschicht (302) angeordnet ist und die erste und die zweite Unterschicht (301, 302) jeweils optische Indizes $n_{301}$ und $n_{302}$ aufweisen, so dass $n_{301} > n_{302}$ und $n_{301} > n_{eff}$, wobei die erste Unterschicht (301) auch eine Dicke $d_{301}$ aufweist, die so ausgelegt ist, dass sie einen Antiresonanzhohlraum für den mindestens einen stationären Modus bildet.

2. System (6) nach dem vorhergehenden Anspruch, **dadurch gekennzeichnet, dass** die Dicke $d_{301}$ der ersten Unterschicht (301) der mindestens einen Doppelschicht (31, 32, 33) derart ist, dass

$$d_{301} \in \left] 0; \frac{\lambda - \delta}{4n_{301}} \right[ \cup \left] \frac{(2p+1)\lambda + \delta}{4n_{301}}; \frac{(2p+3)\lambda - \delta}{4n_{301}} \right[$$

wobei $\lambda$ eine Wellenlänge des mindestens einen stationären Modus, $p \in \mathbb{N}$ und $\delta = \lambda \times 10\%$ ist.

3. System (6) nach einem der Ansprüche 1 bis 2, **dadurch gekennzeichnet, dass** die Dicke $d_{301}$ der ersten Unterschicht (301) der mindestens einen Doppelschicht (31, 32, 33) wie folgt ist

$$d_{301} = \frac{\lambda}{4n_{301}}(2N - 1)\left[ 1 - \frac{n_{eff}^2}{n_{301}^2} + \frac{\lambda^2}{4n_{301}^2 d_{eff}^2} \right]^{-1/2}$$

mit $N \in \mathbb{N}^*$, $\lambda$ einer Wellenlänge des mindestens einen stationären Modus und $d_{eff}$ einer Dicke des stationären Modus.

4. System (6) nach einem der Ansprüche 1 bis 2, **dadurch gekennzeichnet, dass** die Dicke $d_{301}$ der ersten Unterschicht (301) der mindestens einen Doppelschicht (31, 32, 33) wie folgt ist

$$d_{301} \in \left[ \frac{p\lambda - \delta}{2n_{301}}; \frac{p\lambda + \delta}{2n_{301}} \right]$$

mit $\delta = \lambda \times 50\%$.

**5.** System (6) nach einem der vorhergehenden Ansprüche, **dadurch gekennzeichnet, dass** der Antiresonanzreflektor (3) eine Vielzahl von Doppelschichten (31, 32, 33) umfasst, wobei sich die zweite Unterschicht (302) einer ersten Doppelschicht (31) der Vielzahl von Doppelschichten (31, 32, 33) gegen die erste Unterschicht (301) einer zweiten Doppelschicht (32) der Vielzahl von Doppelschichten (31, 32, 33) erstreckt.

**6.** System (6) nach einem der vorhergehenden Ansprüche, **dadurch gekennzeichnet, dass** die Lichtquelle (1) einen Hohlraum (11) umfasst, in dem sich der mindestens eine stationäre Modus des elektromagnetischen Feldes herstellen lässt, wobei der Hohlraum (11) eine erste Schicht (110), die als "aktiver Bereich" bezeichnet wird, und eine zweite Schicht (111), die als "untere Cladding-Schicht" bezeichnet wird, umfasst, wobei sich der aktive Bereich (110) parallel zur Ebene (P) und über die untere Cladding-Schicht (111) erstreckt und die untere Cladding-Schicht (111) zwischen dem aktiven Bereich (110) und dem Reflektor (3) angeordnet ist, wobei der aktive Bereich (110) auch derart gestaltet ist, dass er das elektromagnetische Feld ausstrahlt.

**7.** System (6) nach dem vorhergehenden Anspruch, **dadurch gekennzeichnet, dass** die untere Cladding-Schicht (111) aus III-V-Material wie InP besteht, wobei die erste Unterschicht (301) der mindestens einen Doppelschicht (31, 32, 33) aus Ge besteht und die zweite Unterschicht (302) der mindestens einen Doppelschicht (31, 32, 33) aus Si besteht.

**8.** System (6) nach einem der vorhergehenden Ansprüche, **dadurch gekennzeichnet, dass** es eine Klebeschicht (5) umfasst, die die Lichtquelle (1) und den Reflektor (3) trennt, wobei die Klebeschicht (5) einen optischen Index $n_5$ aufweist, so dass $n_5 \leq n_{301}$.

**9.** System (6) nach dem vorhergehenden Anspruch und einem der Ansprüche 6 oder 7, **dadurch gekennzeichnet, dass** die Klebeschicht (5) eine Seite parallel zur Ebene (P) umfasst, die ein Beugungsgitter (51) umfasst, wobei sich die untere Cladding-Schicht (111) gegen die Seite der Klebeschicht (5) und gegen das Beugungsgitter (51) erstreckt.

**10.** Verfahren (7) zur Herstellung eines Systems (6), das die folgenden Schritte umfasst:

- Bilden (71), ausgehend von einem Substrat (2), das sich parallel zu einer Ebene (P) erstreckt und einen optischen Index $n_2$ aufweist, der kleiner als ein effektiver Index $n_{eff}$ ist, eines Antiresonanzreflektors (3) für mindestens einen stationären Modus parallel zur Ebene (P) eines elektromagnetischen Feldes, wobei sich der Reflektor (3) über das Substrat (2) erstreckt und mindestens eine Halbleiter-Doppelschicht (31, 32, 33) umfasst, die sich parallel zur Ebene (P) erstreckt, wobei die mindestens eine Doppelschicht (31, 32, 33) umfasst: eine erste Halbleiter-Unterschicht (301) und eine zweite Halbleiter-Unterschicht (302), die sich gegen die erste Unterschicht (301) erstreckt, wobei die zweite Unterschicht (302) zwischen der ersten Unterschicht (301) und dem Substrat (2) angeordnet ist und die erste und zweite Unterschicht (301, 302) jeweils einen optischen Index $n_{301}$ und $n_{302}$ aufweisen, so dass $n_{301} > n_{302}$ und $n_{301} > n_{eff}$, wobei die erste Unterschicht (301) auch eine Dicke $d_{301}$ aufweist, die derart ist, dass sie einen Antiresonanzhohlraum für den mindestens einen stationären Modus bildet; und
- Bilden (72) einer Lichtquelle (1) auf dem Reflektor (3), die so ausgelegt ist, dass sie den mindestens einen stationären Modus parallel zur Ebene (P) des elektromagnetischen Feldes aufweist, wobei die Lichtquelle (1) auch derart ausgelegt ist, dass sie für den mindestens einen stationären Modus den effektiven optischen Index $n_{eff}$ aufweist, so dass $n_{eff} < n_2$.

**Claims**

**1.** A system (6) comprising:

- a substrate (2) extending in parallel to a plane (P), said substrate (2) having an optical index $n_2$;
- a light source (1) configured to have at least one stationary mode of an electromagnetic field, said mode being parallel to the plane (P), the source (1) being also configured to have, for said at least one stationary mode, an effective optical index $n_{eff}$ such that $n_{eff} < n_2$;

the system (6) being **characterised in that** it also comprises an anti-resonant reflector (3) for said at least one stationary mode, said reflector extending over the substrate (2) and the source (1) extending over the reflector (3), the reflector (3) comprising at least one semiconductor bilayer (31, 32, 33) extending in parallel to the plane (P), said at least one bilayer (31, 32, 33) comprising: a first semiconductor sublayer (301) and a second semiconductor sublayer (302) extending against the first sublayer (301), the first sublayer (301) being disposed between the source (1) and the second sublayer (302), the first and second sublayers (301, 302) respectively having optical indices $n_{301}$ and $n_{302}$ such that $n_{301} > n_{302}$ and $n_{301} > n_{\text{eff}}$, the first sublayer (301) also having a thickness $d_{301}$ configured to form an anti-resonant cavity for said at least one stationary mode.

2. The system (6) according to the preceding claim, **characterised in that** the thickness $d_{301}$ of the first sublayer (301) of said at least one bilayer (31, 32, 33) is such that

$$d_{301} \in \left]0; \frac{\lambda - \delta}{4n_{301}}\right[ \cup \left]\frac{(2p + 1)\lambda + \delta}{4n_{301}}; \frac{(2p + 3)\lambda - \delta}{4n_{301}}\right[$$

where $\lambda$ is a wavelength of said at least one stationary mode, $p \in \mathbb{N}$ and $\delta = \lambda \times 10\%$.

3. The system (6) according to one of claims 1 to 2, **characterised in that** the thickness $d_{301}$ of the first sublayer (301) of said at least one bilayer (31, 32, 33) is

$$d_{301} = \frac{\lambda}{4n_{301}}(2N - 1)\left[1 - \frac{n_{\text{eff}}^2}{n_{301}^2} + \frac{\lambda^2}{4n_{301}^2 d_{\text{eff}}^2}\right]^{-1/2}$$

with $N \in \mathbb{N}^*$, $\lambda$ a wavelength of the at least one stationary mode and $d_{\text{eff}}$ a thickness of the stationary mode.

4. The system (6) according to one of claims 1 to 2, **characterised in that** the thickness $d_{301}$ of the first sublayer (301) of said at least one bilayer (31, 32, 33) is

$$d_{301} \in \left[\frac{p\lambda - \delta}{2n_{301}}; \frac{p\lambda + \delta}{2n_{301}}\right]$$

with $\delta = \lambda \times 50\%$.

5. The system (6) according to one of preceding claims, **characterised in that** the anti-resonant reflector (3) comprises a plurality of bilayers (31, 32, 33), the second sublayer (302) of a first bilayer (31) of the plurality of bilayers (31, 32, 33) extending against the first sublayer (301) of a second bilayer (32) of the plurality of bilayers (31, 32, 33).

6. The system (6) according to one of the preceding claims, **characterised in that** the source (1) comprises a cavity (11) in which said at least one stationary mode of the electromagnetic field can be established, the cavity (11) comprising a first layer (110) called the "active region" and a second layer (111) called the "lower cladding layer", the active region (110) extending in parallel to the plane (P) and over the lower cladding layer (111), the lower cladding layer (111) being disposed between the active region (110) and the reflector (3), the active region (110) being also configured to emit the electromagnetic field.

7. The system (6) according to the preceding claim, **characterised in that** the lower cladding layer (111) is made of III-V material, such as InP, the first sublayer (301) of said at least one bilayer (31, 32, 33) being made of Ge and the second sublayer (302) of said at least one bilayer (31, 32, 33) being made of Si.

8. The system (6) according to one of the preceding claims, **characterised in that** it comprises a bonding layer (5) separating the source (1) and the reflector (3), the bonding layer (5) having an optical index $n_5$ such that $n_5 \leq n_{301}$.

9. The system (6) according to the preceding claim and one of claims 6 or 7, **characterised in that** the bonding layer (5) comprises a face, parallel to the plane (P), comprising a diffraction grating (51), the lower cladding layer (111) extending against said face of the bonding layer (5), against the diffraction grating (51).

10. A method (7) for manufacturing a system (6) comprising the following steps of:

- forming (71), from a substrate (2) extending in parallel to a plane (P) and having an optical index $n_2$ less than an effective index $n_{eff}$, an anti-resonant reflector (3) for at least one stationary mode parallel to the plane (P) of an electromagnetic field, said reflector extending over the substrate (2), the reflector (3) comprising at least one semiconductor bilayer (31, 32, 33) extending in parallel to the plane (P), said at least one bilayer (31, 32, 33) comprising: a first semiconductor sublayer (301) and a second semiconductor sublayer (302) extending against the first sublayer (301), the second sublayer (302) being disposed between the first sublayer (301) and the substrate (2), the first and second sublayers (301, 302) respectively having optical indices $n_{301}$ and $n_{302}$ such that $n_{301} > n_{302}$ and $n_{301} > n_{eff}$, the first sublayer (301) also having a thickness $d_{301}$ configured to form an anti-resonant cavity for said at least one stationary mode; and

- forming (72), on the reflector (3), a light source (1) configured to have said at least one stationary mode parallel to the plane (P) of the electromagnetic field, the source (1) being also configured to have, for said at least one stationary mode, the effective optical index $n_{eff}$ such that $n_{eff} < N_y$.

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

[Fig. 11]

[Fig. 12]

[Fig. 13]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015260913 A1

**Littérature non-brevet citée dans la description**

- **COUTARD, J.G** ; **BRUN, M** ; **FOURNIER, M et al.** Volume Fabrication of Quantum Cascade Lasers on 200 mm-CMOS pilot line. *Sci Rep*, 2020, vol. 10, 6185